# FASCICULE DE BREVET EUROPEEN

(11) **EP 2 990 811 B1**
(45) Date de publication et mention de la délivrance du brevet: **09.08.2017**
(21) Numéro de dépôt: 15172421.8
(22) Date de dépôt: 16.06.2015
(51) Int. Cl.: G01R 15/06, G01R 15/16, G01R 19/00, G01R 27/26

(54) **DISPOSITIF DE MESURE SANS CONTACT D'UNE TENSION ELECTRIQUE DANS UN CABLE DE RESEAU ELECTRIQUE MOYENNE OU HAUTE TENSION**
KONTAKTLOSE MESSVORRICHTUNG FÜR ELEKTRISCHE SPANNUNG IN EINEM MITTEL- ODER HOCHSPANNUNGS-STROMNETZKABEL
DEVICE FOR CONTACTLESS MEASUREMENT OF AN ELECTRICAL VOLTAGE IN A CABLE OF A MEDIUM- OR HIGH-VOLTAGE ELECTRIC NETWORK

(30) Priorité: 21.08.2014 FR 1457912
(43) Date de publication de la demande: 02.03.2016
(73) Titulaire: Nexans, 92400 Courbevoie (FR)
(72) Inventeur: DE RIDDER, Eduard, 9310 Herdersem (BE); WEYGAERTS, Kevin, 9310 Meldert (BE); KEYMEULEN, Heilke, 9700 Oudenaarde (BE); CARDINAELS, Jozef, 9230 Wetteren (BE)
(74) Mandataire: Hervouet-Malbec, Sylvie

(56) Documents cités:
- EP-A1- 1 022 749
- EP-A1- 2 608 339
- EP-A1- 2 763 259
- DE-A1- 3 145 255
- US-A1- 2014 021 965
- Www: "Medium voltage separable connectors and bushings - Interface B -", , 31 décembre 2006 (2006-12-31), XP055186708, www.cablejoints.co.uk Extrait de l'Internet: URL:http://www.cablejoints.co.uk/upload/Eu romold-Connectors-400-Series-Elbows---Inte rface-Type-B-Bushing.pdf [extrait le 2015-04-29]

## Description

La présente invention est relative à la mesure d'une tension électrique dans un câble utilisé dans un réseau de transmission ou de distribution d'énergie à haute ou moyenne tension.

On connaît déjà des systèmes permettant de réaliser la mesure de la tension dans un câble sans avoir de contact direct avec le conducteur central du câble. Ces systèmes utilisent un diviseur de tension de type capacitif en prévoyant un élément capacitif sur le câble de façon à pouvoir mesurer la tension à n'importe quelle position du câble.

En particulier, le document WO 2012/130816 décrit un dispositif de mesure sans contact d'une tension électrique dans un câble moyenne ou haute tension utilisant la structure même du câble électrique pour réaliser un élément capacitif. Conformément à l'enseignement de ce document, le câble électrique est du type comprenant un conducteur central entouré successivement d'une première couche diélectrique, d'une couche semi-conductrice, puis d'une couche semi-conductrice de blindage. Une couche métallique disposée coaxialement sur la couche semi-conductrice forme une électrode de détection d'un condensateur de détection, l'autre électrode du condensateur de détection étant directement constituée par la partie du conducteur central du câble en regard de la couche métallique. La couche métallique formant électrode de détection est accompagnée de deux électrodes de garde de part et d'autre de l'électrode de détection, l'ensemble étant entouré d'une couche isolante puis d'un écran électrostatique relié électriquement à la couche de blindage du câble électrique. L'électrode de détection d'une part et les électrodes de garde et l'écran électrostatique d'autre part sont reliés par l'intermédiaire d'un câble coaxial à un circuit électrique de traitement apte à dériver en continu une mesure de la tension électrique dans le câble.

L'inconvénient majeur de ce dispositif est qu'il doit être monté directement sur le semi-conducteur d'un câble. Dans le cas d'une installation nouvelle, le montage se fait au moment de la préparation de la connexion et a comme inconvénient qu'il s'ajoute à la longueur nécessaire pour raccorder le câble. Pour installer un tel dispositif sur un câble déjà en service, l'intervention est complexe, couteuse et risque de perturber le fonctionnement de la connexion de câble existante parce qu'il faut intervenir sur plusieurs couches extérieures du câble et les enlever en partie.

On connaît par ailleurs également des connecteurs séparables pour câble électrique utilisés pour raccorder un câble à isolation synthétique à des appareillages de type transformateurs, interrupteurs, cellules, moteurs..., ou encore pour raccorder des câbles entre eux.

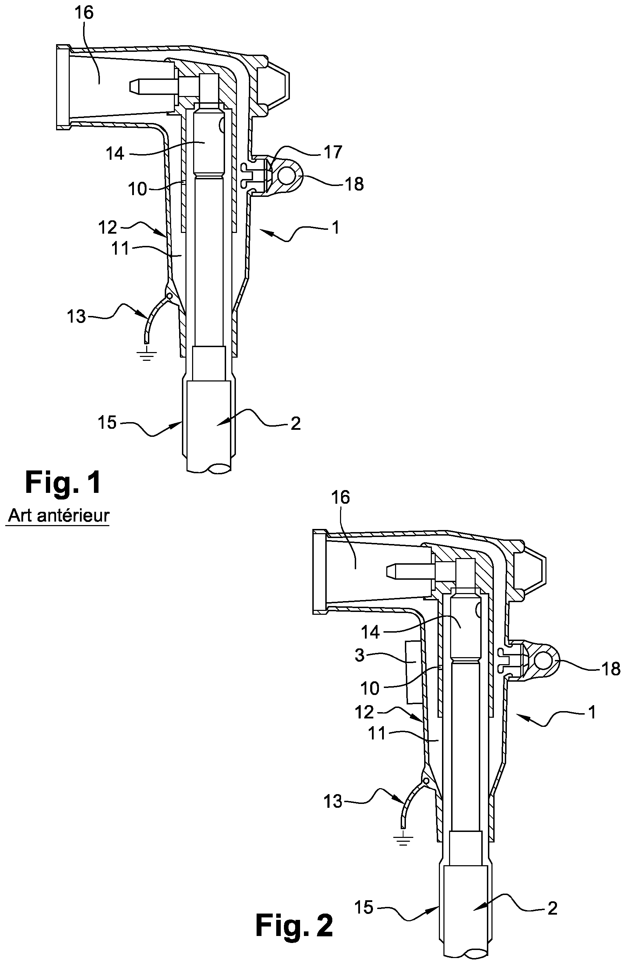

La figure 1 illustre par exemple un tel connecteur séparable 1, ici de type coudé, commercialisé par la Demanderesse, recevant une extrémité d'un câble électrique 2. Le connecteur 1 comprend ici un insert 10 en couche semi-conductrice, de forme sensiblement cylindrique, entouré intégralement d'une couche 11 en matériau isolant elle-même entourée d'une enveloppe externe 12 en matériau semi-conducteur. L'enveloppe externe 12 est mise à la terre par une connexion 13.

L'insert 10 est adapté pour recevoir un connecteur métallique 14, lui-même adapté pour recevoir, comme montré sur la figure 1, l'extrémité dénudée du câble électrique 2, c'est-à-dire l'extrémité du conducteur central de ce câble électrique 2. Un adaptateur de câble 15 peut être utilisé pour s'adapter si nécessaire à la section du câble électrique 2. Le connecteur 1 comporte également une interface 16 de type A ou autre, conforme à la norme CENELEC EN 50180 et 50181.

Ce type de connecteur séparable 1 comporte également en général un point de test 17 réalisé localement sur l'enveloppe externe 12 et surmonté d'un bouchon amovible 18 en matériau semi-conducteur, qui met le point de test à la terre en fonction normale. Ce point de test permet de prélever localement, par couplage capacitif et après avoir enlevé le bouchon, une image représentative de la tension dans le câble 2. La mesure de tension n'est cependant pas suffisamment précise, et n'est utilisée généralement que très ponctuellement, pour vérifier la présence ou l'absence d'une tension dans le câble, en particulier avant une intervention humaine sur la connexion du câble avec l'appareillage.

Un tel point de test n'est ainsi pas utilisable pour permettre de mesurer avec précision et de façon continue la tension dans un câble électrique de moyenne ou haute tension.

La présente invention a pour but de pallier les limitations des solutions connues en proposant une solution simple et moins coûteuse qui puisse être déployée aisément sur des réseaux de transmission ou de distribution d'énergie électrique déjà existants et permette d'obtenir en continu une mesure précise de la tension des câbles électriques de ces réseaux.

Pour ce faire, l'invention a pour objet un dispositif de mesure sans contact d'une tension électrique dans un câble de réseau électrique moyenne ou haute tension, le dispositif de mesure comportant une électrode de détection connectée à un circuit électrique de traitement apte à dériver en continu une mesure de la tension électrique dans le câble, caractérisé en ce que l'électrode de détection est une couche métallique d'une face interne d'un module apte à être fixé, de manière amovible, sur un connecteur séparable pour câble électrique moyenne ou haute tension, le connecteur séparable comprenant un insert en couche semi-conductrice, entouré d'une couche en matériau isolant elle-même entourée d'une enveloppe externe en matériau semi-conducteur, ledit insert étant adapté pour recevoir un connecteur métallique entourant une extrémité d'un conducteur central du câble, ledit module étant apte à être fixé coaxialement sur l'enveloppe externe en enveloppant une portion de l'enveloppe externe de sorte que l'électrode de détection soit en contact avec ladite portion de l'enveloppe externe en regard de l'insert.

Selon d'autres particularités possibles du dispositif :
- le module est de préférence apte à envelopper la portion de l'enveloppe externe selon un arc de cercle de longueur supérieure à la moitié du diamètre extérieur de ladite portion de l'enveloppe externe, et sur une longueur axiale supérieure à la moitié de la longueur axiale de l'insert;
- l'électrode de détection peut s"étendre alors sur sensiblement toute la longueur de l'arc de cercle ;
- le module comporte de préférence un empilement de couches, une première couche correspondant à la face interne du module et formée, au moins partiellement par ladite électrode de détection, une couche intermédiaire en matériau diélectrique, et une troisième couche en matériau conducteur ou semi-conducteur formant une surface externe du module ;
- la troisième couche est apte à venir en contact mécanique avec l'enveloppe externe du connecteur séparable de façon à être portée au même potentiel électrique ;
- le module comporte avantageusement un dispositif d'auto fixation sur sa surface externe ;
- ce dispositif d'auto fixation peut comporter au moins une bride et un point d'attache pour une extrémité libre de la bride ;
- la première couche du module peut comporter également deux électrodes de garde s'étendant à distance, le long et de part et d'autre de l'électrode de détection, les deux électrodes de garde venant également en contact avec ladite portion de l'enveloppe externe en regard de l'insert lorsque le module est monté sur le connecteur séparable ;
- l'électrode de détection est connectée au circuit électrique de traitement par l'intermédiaire d'un conducteur central d'un câble coaxial ou par des paires torsadées d'un câble écranté ou non;
- le module peut être réalisé sous la forme d'une bague sensiblement cylindrique fendue radialement sur toute sa longueur et élastiquement déformable de manière à autoriser un montage radial sur l'enveloppe externe du connecteur séparable ; la fente de la bague est alors prévue suffisamment large pour autoriser la bague à venir de part et d'autre d'un point de test du connecteur séparable, si celui-ci est pourvu d'un tel point de test ;
- en variante, le module peut être réalisé sous la forme d'un ruban souple sensiblement rectangulaire apte à venir épouser la forme de la portion de l'enveloppe externe du connecteur séparable.

L'invention sous ses différents aspects sera mieux comprise au vu de la description suivante non limitative d'un dispositif de mesure sans contact d'une tension électrique dans un câble de réseau électrique moyenne ou haute tension, faite en référence aux figures annexées, dans lesquelles :
- la figure 1, déjà décrite, représente les éléments constitutifs d'un connecteur séparable connu auquel est connecté un câble électrique ;
- la figure 2 illustre schématiquement la coopération d'un dispositif de mesure avec le connecteur séparable de la figure 1, conformément à l'invention ;
- la figure 3 représente une vue en perspective d'un connecteur séparable portant un dispositif de mesure conforme à l'invention ;
- la figure 4 est une vue partielle en coupe du connecteur séparable de la figure 3, muni du dispositif de mesure ;
- la figure 5 est une vue agrandie d'une partie de la figure 3 ;
- la figure 6 représente un dispositif de mesure selon un deuxième mode de réalisation possible conforme à l'invention.

Dans la suite de l'exposé, les éléments communs aux différentes figures portent les mêmes références.

On retrouve sur la figure 2 la même vue en coupe du connecteur séparable 1 décrit ci-avant en référence à la figure 1, avec son insert 10 en couche semi-conductrice, entouré d'une couche 11 en matériau isolant elle-même entourée d'une enveloppe externe 12 en matériau semi-conducteur, et le connecteur métallique 14 recevant une extrémité du conducteur central d'un câble 2, ce connecteur 14 venant s'enficher dans l'insert 10, éventuellement en coopération avec un adaptateur 15.

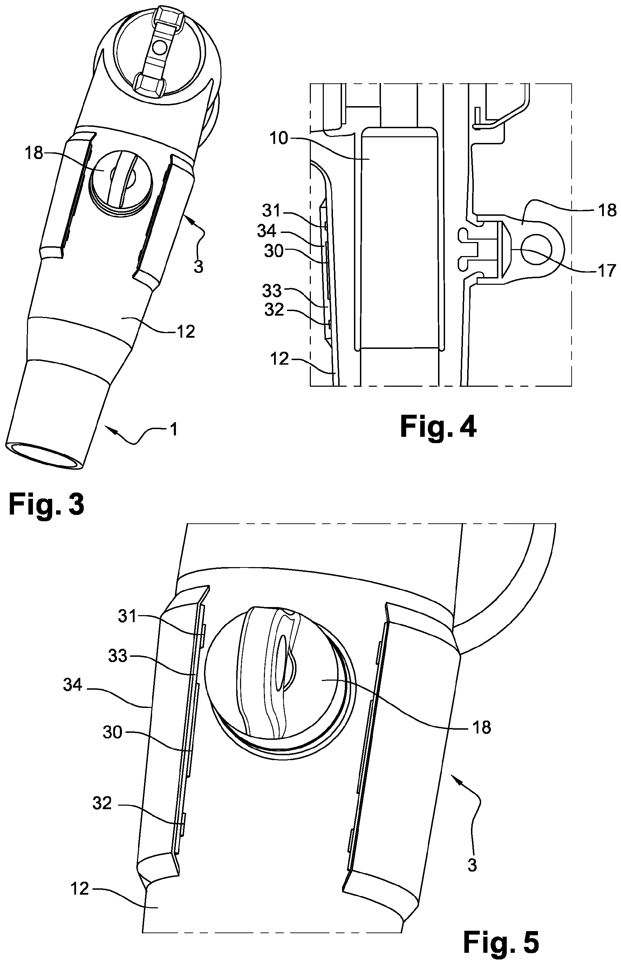

Conformément à l'invention, le dispositif de mesure comporte une électrode de détection connectée à un circuit électrique de traitement (non représenté) apte à dériver en continu une mesure de la tension électrique dans le câble 2, cette électrode de détection étant formée par une couche métallique d'une face interne d'un module 3 apte à être fixé, de manière amovible, sur le connecteur séparable 1. Comme plus particulièrement visible sur les figures 3 et 5, le module 3 est fixé coaxialement sur l'enveloppe externe 12 du connecteur séparable 1, en enveloppant une portion de l'enveloppe externe de sorte que l'électrode de détection 30 soit en contact avec ladite portion de l'enveloppe externe en regard de l'insert 10. Un condensateur de couplage est ainsi formé, dont les deux électrodes correspondent respectivement à l'électrode de détection 30, et à l'insert 10 recevant le conducteur central du câble et dont le diélectrique est formé par la couche 11 en matériau isolant du connecteur séparable 1.

Le module 3 est de préférence dimensionné de façon à envelopper la portion de l'enveloppe externe 12 selon un arc de cercle de longueur supérieure à la moitié du diamètre extérieur de ladite portion de l'enveloppe externe 12, et sur une longueur axiale supérieure à la moitié de la longueur axiale de l'insert 10.

Le module 3 entoure ainsi une majeure partie de la portion de l'enveloppe externe 12 lorsqu'il est monté sur le connecteur 1, tout en laissant libre le passage pour le point de test 18 lorsque celui-ci existe.

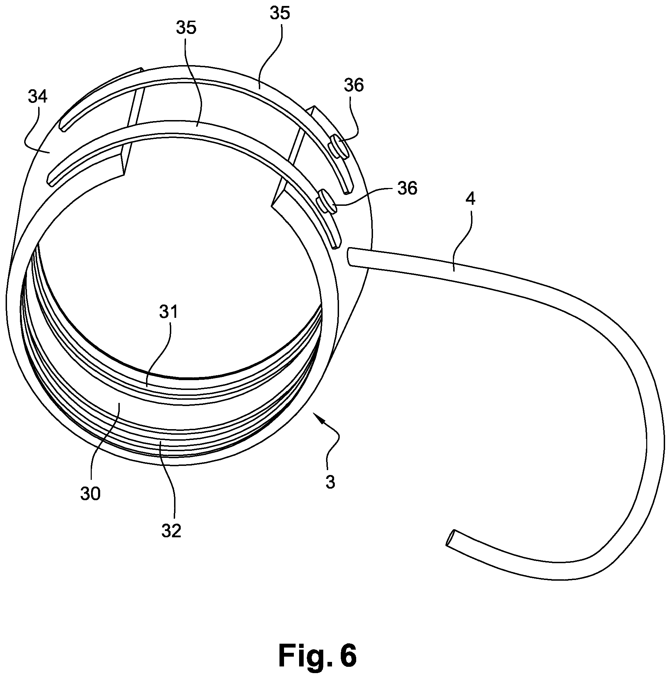

Par ailleurs, l'électrode de détection 30 s'étend sur sensiblement toute la longueur de l'arc de cercle, comme particulièrement visible sur la figure 6. Le couplage capacitif, et donc la mesure de la tension dans le conducteur central du câble se voient ainsi grandement améliorés du fait que l'électrode de détection 30 s'étend coaxialement en regard d'une large portion du conducteur de câble.

Le module 3 comporte essentiellement un empilement de couches, une première couche correspondant à la face interne du module et formée, au moins partiellement par l'électrode de détection 30, une couche intermédiaire 33 en matériau diélectrique, et une troisième couche 34 en matériau conducteur ou semi-conducteur formant une surface externe du module 3.

Comme représenté sur les figures 3 à 5, la troisième couche 34 formant surface externe du module est conformée de manière à venir en contact mécanique avec l'enveloppe externe 12 du connecteur séparable 1. Cette couche externe 34 est ainsi portée au même potentiel électrique, en l'occurrence mis à la terre par la connexion MALT 13 du connecteur séparable 1.

Dans le mode de réalisation préféré, deux électrodes dites de garde 31 et 32 sont en outre prévues sur la première couche formant face interne du module 3, pour protéger le champ électrique de l'électrode de détection 30 de l'influence de l'environnement. Ces deux électrodes de garde 31, 32 sont des couches métalliques s'étendant à distance, le long et de part et d'autre de l'électrode de détection 30. Ces deux électrodes de garde 31, 32 viennent ainsi également en contact avec la portion de l'enveloppe externe 12 en regard de l'insert 10 lorsque le module 3 est monté sur le connecteur séparable 1. L'électrode de détection 30 et, le cas échéant les électrodes de garde 31, 32 sont reliées électriquement à un circuit électrique de traitement (non représenté) par l'intermédiaire d'un câble coaxial 4 (voir figure 4). Le circuit électrique de traitement, par exemple celui décrit dans le document WO 2012/130816, dérive alors en continu une valeur très précise de la tension dans le conducteur central du câble 2.

Le module 3 comporte de préférence un dispositif permettant son auto fixation autour de l'enveloppe externe du connecteur séparable 1.

Le module 3 est par exemple réalisé sous la forme d'une bague sensiblement cylindrique fendue radialement sur toute sa longueur et élastiquement déformable. On autorise ainsi un montage radial du module 3 sur l'enveloppe externe 12 du connecteur séparable 1. Les dimensions en section de la bague sont adaptées pour permettre une auto fixation par clippage. La fente de la bague doit être prévue suffisamment large pour autoriser la bague à venir de part et d'autre du bouchon amovible 18 recouvrant un point de test 17 du connecteur séparable 1, lorsque ce point de test existe.

En variante, conformément à la figure 6, au moins une bride 35, de préférence deux brides, et leur point d'attache respectif 36 permettant l'attache de l'extrémité libre de chaque bride, sont prévus pour permettre l'auto fixation du module 3 sur le connecteur 1. Dans ce cas, l'espacement entre les deux brides 35 doit autoriser le passage du bouchon amovible 18 du point de test si nécessaire.

Le module 3 avec ses empilements successifs de couches peut aussi être réalisé sous la forme d'un ruban sensiblement rectangulaire et suffisamment souple pour venir épouser la forme de la portion de l'enveloppe externe 12 du connecteur séparable 1.

Grâce à la présente invention, il est possible d'équiper facilement des connecteurs séparables de câbles électriques déjà déployés dans le réseau de transmission ou de distribution d'énergie avec le module 3, de façon à pouvoir mesurer avec une précision améliorée et en continu la tension dans les câbles à divers points du réseau.

## Revendications

1. Dispositif de mesure sans contact d'une tension électrique dans un câble de réseau électrique (2) moyenne ou haute tension, le dispositif de mesure comportant une électrode de détection (30) connectée à un circuit électrique de traitement apte à dériver en continu une mesure de la tension électrique dans le câble (2), **caractérisé en ce que** l'électrode de détection (30) est une couche métallique d'une face interne d'un module (3) apte à être fixé, de manière amovible, sur un connecteur séparable (1) pour câble électrique moyenne ou haute tension, le connecteur séparable (1) comprenant un insert (10) en couche semi-conductrice, entouré d'une couche (11) en matériau isolant elle-même entourée d'une enveloppe externe (12) en matériau semi-conducteur, ledit insert (10) étant adapté pour recevoir un connecteur métallique (14) entourant une extrémité d'un conducteur central du câble (2), ledit module (3) étant apte à être fixé coaxialement sur l'enveloppe externe (12) en enveloppant une portion de l'enveloppe externe de sorte que l'électrode de détection (30) soit en contact avec ladite portion de l'enveloppe externe en regard de l'insert (10).

2. Dispositif de mesure selon la revendication 1, **caractérisé en ce que** ledit module (3) est apte à envelopper ladite portion de l'enveloppe externe (12) selon un arc de cercle de longueur supérieure à la moitié du diamètre extérieur de ladite portion de l'enveloppe externe (12), et sur une longueur axiale supérieure à la moitié de la longueur axiale de l'insert (10).

3. Dispositif de mesure selon la revendication 2, **caractérisé en ce que** l'électrode de détection (30) s'étend sur sensiblement toute la longueur de l'arc de cercle.

4. Dispositif de mesure selon l'une quelconque des revendications précédentes, **caractérisé en ce que** ledit module (3) comporte un empilement de couches, une première couche correspondant à la face interne du module et formée, au moins partiellement par ladite électrode de détection (30), une couche intermédiaire (33) en matériau diélectrique, et une troisième couche (34) en matériau conducteur ou semi-conducteur formant une surface externe du module (3).

5. Dispositif de mesure selon la revendication 4, **caractérisé en ce que** la troisième couche (34) est apte à venir en contact mécanique avec l'enveloppe externe (12) du connecteur séparable (1) de façon à être portée au même potentiel électrique.

6. Dispositif de mesure selon l'une quelconque des revendications 4 ou 5, **caractérisé en ce que** le module (3) comporte un dispositif d'auto fixation (35, 36) sur sa surface externe.

7. Dispositif de mesure selon la revendication 6, **caractérisé en ce que** le dispositif d'auto fixation (35, 36) comporte au moins une bride (35) et un point d'attache (36) pour une extrémité libre de la bride.

8. Dispositif de mesure selon l'une des revendications 4 à 7, **caractérisé en ce que** la première couche comporte également deux électrodes de garde (31, 32) s'étendant à distance, le long et de part et d'autre de l'électrode de détection (30), les deux électrodes de garde (31, 32) venant également en contact avec ladite portion de l'enveloppe externe (12) en regard de l'insert (10) lorsque le module (3) est monté sur le connecteur séparable (1).

9. Dispositif de mesure selon l'une quelconque des revendications précédentes, **caractérisé en ce que** l'électrode de détection (30) est connectée au circuit électrique de traitement par l'intermédiaire d'un conducteur central d'un câble coaxial (4) ou par des paires torsadées d'un câble écranté ou non.

10. Dispositif de mesure selon l'une quelconque des revendications précédentes, **caractérisé en ce que** ledit module (3) est réalisé sous forme d'une bague sensiblement cylindrique fendue radialement sur toute sa longueur et élastiquement déformable de manière à autoriser un montage radial sur l'enveloppe externe (12) du connecteur séparable (1).

11. Dispositif de mesure selon la revendication 10, **caractérisé en ce que** la fente de la bague est suffisamment large pour autoriser la bague à venir de part et d'autre d'un point de test (17, 18) du connecteur séparable (1).

12. Dispositif de mesure selon l'une quelconque des revendications 1 à 10, **caractérisé en ce que** ledit module (3) est réalisé sous forme d'un ruban souple sensiblement rectangulaire apte à venir épouser la forme de la portion de l'enveloppe externe (12) du connecteur séparable (1).

## Patentansprüche

1. Vorrichtung zum kontaktlosen Messen einer elektrischen Spannung in einem Hoch- oder Mittelspannungs-Stromnetzkabel (2), wobei die Messvorrichtung eine Detektionselektrode (30) umfasst, die an einen Verarbeitungsstromkreis angeschlossen ist, der geeignet ist, um durchgehend eine Messung der elektrischen Spannung in dem Kabel (2) abzuleiten, **dadurch gekennzeichnet, dass** die Detektionselektrode (30) eine Metallschicht einer internen Seite eines Moduls (3) ist, das geeignet ist, um abnehmbar an einem trennbaren Stecker (1) für Mittel- oder Hochspannungs-Stromkabel befestigt zu sein, wobei der trennbare Stecker (1) ein Einsatzteil (10) in einer Halbleiterschicht umfasst, das von einer Schicht (11) aus Isoliermaterial umgeben ist, die wiederum von einer externen Hülle (12) aus Halbleitermaterial umgeben ist, wobei das Einsatzteil (10) geeignet ist, um einen Metallstecker (14) aufzunehmen, der ein Ende eines mittleren Leiters des Kabels (2) umgibt, wobei das Modul (3) geeignet ist, um koaxial an der externen Hülle (12) befestigt zu sein, wobei es einen Abschnitt der externen Hülle umhüllt, so dass die Detektionselektrode (30) in Kontakt mit dem externen Hüllenabschnitt gegenüber dem Einsatzteil (10) steht.

2. Messvorrichtung nach Anspruch 1, **dadurch gekennzeichnet, dass** das Modul (3) geeignet ist, um den externen Hüllenabschnitt (12) an einem Kreisbogen entlang, dessen Länge größer als die Hälfte des Außendurchmessers des externen Hüllenabschnitts (12) ist, und über eine axiale Länge, die größer als die Hälfte der axialen Länge des Einsatzteils (10) ist, zu umhüllen.

3. Messvorrichtung nach Anspruch 2, **dadurch gekennzeichnet, dass** sich die Detektionselektrode (30) im Wesentlichen über die gesamte Länge des Kreisbogens erstreckt.

4. Messvorrichtung nach einem der vorhergehenden Ansprüche, **dadurch gekennzeichnet, dass** das Modul (3) einen Schichtstapel umfasst, wobei eine erste Schicht der internen Seite des Moduls entspricht und mindestens teilweise durch die Detektionselektrode (30), eine Zwischenschicht (33) aus dielektrischen Material und eine dritte Schicht (34) aus einem leitenden oder halbleitenden Material, das eine externe Oberfläche des Moduls (3) bildet, gebildet ist.

5. Messvorrichtung nach Anspruch 4, **dadurch gekennzeichnet, dass** die dritte Schicht (34) geeignet ist, um in mechanischen Kontakt mit der externen Hülle (12) des trennbaren Steckers (1) zu kommen, um auf das gleiche elektrische Potential gebracht zu werden.

6. Messvorrichtung nach einem der Ansprüche 4 oder 5, **dadurch gekennzeichnet, dass** das Modul (3) eine Selbstfixierungsvorrichtung (35, 36) auf seiner externen Oberfläche umfasst.

7. Messvorrichtung nach Anspruch 6, **dadurch gekennzeichnet, dass** die Selbstfixierungsvorrichtung (35, 36) mindestens eine Schelle (35) und einen Anbringungspunkt (36) für ein freies Ende der Schelle umfasst.

8. Messvorrichtung nach einem der Ansprüche 4 bis 7, **dadurch gekennzeichnet, dass** die erste Schicht auch zwei Schutzelektroden (31, 32) umfasst, die sich in einem Abstand entlang und auf beiden Seiten der Detektionselektrode (30) erstrecken, wobei die beiden Schutzelektroden (31, 32) auch mit dem externen Hüllenabschnitt (12) gegenüber dem Einsatzteil (10) in Kontakt kommen, wenn das Modul (3) an dem trennbaren Stecker (1) montiert ist.

9. Messvorrichtung nach einem der vorhergehenden Ansprüche, **dadurch gekennzeichnet, dass** die Detektionselektrode (30) über einen mittleren Leiter eines Koaxialkabels (4) oder über verdrillte Doppelleitungen eines abgeschirmten oder nicht abgeschirmten Kabels an den Verarbeitungsstromkreis angeschlossen ist.

10. Messvorrichtung nach einem der vorhergehenden Ansprüche, **dadurch gekennzeichnet, dass** das Modul (3) in Form eines im Wesentlichen zylindrischen Rings ausgebildet ist, der über seine gesamte Länge radial geschlitzt ist und elastisch verformbar ist, um eine radiale Montage auf der externen Hülle (12) des trennbaren Steckers (1) zu erlauben.

11. Messvorrichtung nach Anspruch 10, **dadurch gekennzeichnet, dass** der Schlitz des Rings groß genug ist, um den Ring von beiden Seiten eines Prüfpunkts (17, 18) des trennbaren Steckers (1) heranzulassen.

12. Messvorrichtung nach einem der Ansprüche 1 bis 10, **dadurch gekennzeichnet, dass** das Modul (3) in der Form eines flexiblen, im Wesentlichen rechtwinkligen Bandes ausgebildet ist, das geeignet ist, um sich an die Form des Abschnitts der externen Hülle (12) des trennbaren Steckers (1) anzupassen.

## Claims

1. A contactless measuring device for electrical voltage in a medium- or high-voltage power grid (2), the measuring device including a detection electrode (30) connected to an electrical processing circuit able to continuously derive a measurement of the electrical voltage in the cable (2), **characterized in that** the detection electrode (30) as a metal layer of an inner face of a module (3) able to be fastened, removably, on a separable connector (1) for a medium or high voltage power cable, the separable connector (1) comprising an insert (10) made from semiconductive layer, surrounded by a layer (11) of insulating material in turn surrounded by an outer enclosure (12) made from semiconductor material, said insert (10) being suitable for receiving a metal connector (14) surrounding one end of a central conductor of the cable (2), said module (3) being able to be fastened coaxially on the outer enclosure (12) wall surrounding a portion of the outer enclosure such that the detection electrode (30) is in contact with said portion of the outer enclosure opposite the insert (10).

2. The measuring device according to claim 1, **characterized in that** said module (3) is able to surround said portion of the outer enclosure (12) along an arc of circle with a length greater than half of the outer diameter of said portion of the outer enclosure (12), and over an axial length greater than half of the axial length of the insert (10).

3. The measuring device according to claim 2, **characterized in that** the detection electrode (30) extends over substantially the entire length of the arc of circle.

4. The measuring device according to any one of the preceding claims, **characterized in that** said module (3) includes a stack of layers, a first layer corresponding to the inner face of the module informed, at least partially, by said detection electrode (30), an intermediate layer (33) made from a dielectric material, and a third layer (34) made from a conductive or semiconductive material forming an outer surface of the module (3).

5. The measuring device according to claim 4, **characterized in that** the third layer (34) is able to come and mechanical contact with the outer enclosure (12) of the separable connector (1) so as to be brought to the same electric potential.

6. The measuring device according to any one of claims 4 or 5, **characterized in that** the module (3) includes a self-fastening device (35, 36) on its outer surface.

7. The measuring device according to claim 6, **characterized in that** the self-fastening device (35, 36) includes at least one flange (35) and a fastening point (36) for a free end of the flange.

8. The measuring device according to one of claims 4 to 7, **characterized in that** the first layer also includes two current electrodes (31, 32) extending at a distance, along and on both sides of the detection electrode (30), the two-part electrodes (31, 32) also coming into contact with said portion of the outer enclosure (12) across from the insert (10) when the module (3) is mounted on the separable connector (1).

9. The measuring device according to any one of the preceding claims, **characterized in that** the detection electrode (30) is connected to the electrical processing circuit via a central conductor of a coaxial cable (4) or by twisted pairs of a notched or non-notched table.

10. The measuring device according to any one of the preceding claims, **characterized in that** said module (3) is made in the form of a substantially cylindrical ring slitted radially over its entire length and elastically deformable so as to allow radial mounting on the outer enclosure (12) of the separable connector (1).

11. The measuring device according to claim 10, **characterized in that** the slit of the ring is wide enough to allow the ring two, both sides of the test point (17, 18) of the separable connector (1).

12. The measuring device according to any one of claims 1 to 10, **characterized in that** said module (3) is made in the form of a substantially rectangular flexible tape able to Mary the shape of the portion of the outer enclosure (12) of the separable connector (1).
